# EUROPEAN PATENT APPLICATION

(11) **EP 1 705 696 A2**
(43) Date of publication of application: **27.09.2006**
(21) Application number: 06006040.7
(22) Date of filing: 23.03.2006
(51) Int. Cl.: H01L 21/04, H01L 29/24, H01L 29/04

(54) **SiC semiconductor device**

(30) Priority: 25.03.2005 JP 2005089632
(71) Applicant: SHINDENGEN ELECTRIC MANUFACTURING CO., LTD., Tokyo, 100-0004 (JP); HONDA MOTOR CO., Ltd., Tokyo (JP)
(72) Inventor: Maeyama, Yusuke Shindengen Electric MFG, Co., Ltd., Hanno-shi Saitama 357-8585 (JP); Nishikawa, Koichi Shindengen Electric MFG, Co. Ltd, Hanno-shi Saitama 357-8585 (JP); Fukuda, Yusuke Shindengen Electric MFG, Co., Ltd., Hanno-shi Saitama 357-8585 (JP); Shimizu, Masaaki Shindengen Electric MFG, Co., Ltd, Hanno-shi Saitama 357-8585 (JP); Satoh, Masashi Shindengen Electric MFG, Co., Ltd., Hanno-shi Saitama 357-8585 (JP); Iwakuro, Hiroaki Shindengen Electric MFG, Co., Ltd, Hanno-shi Saitama 357-8585 (JP); Nonaka, Kenichi Honda R&D Co., Ltd., Wako-shi Saitama 351-0193 (JP)
(74) Representative: Jordan, Volker Otto Wilhelm

(57) **Abstract**

A semiconductor device includes: a passivation film (103, 114, 115, 127); a first semiconductor layer (101, 112, 123) that has a first main component of 4H-SiC of a first conductivity type; and a second semiconductor layer (102, 113, 124) that has a second main component of 4H-SiC of a second conductivity type. The second semiconductor layer (102, 113, 124) has a pn-junction (26) with the first semiconductor layer (101, 112, 123). The pn-junction (26) has a junction edge (P1). The first and second semiconductor layers (101, 102, 112, 113, 123, 124) further include a local area (31, 32, 33) that includes the junction edge (P1). The local area (31, 32, 33) has a first principal plane that interfaces with the passivation film (103, 114, 115, 127). A normal (C1, C2, C3) to the first principal plane tilts by a first tilt angle ( θ 1, θ 2, θ 3) in a range of 25 degrees to 45 degrees from a first axis of [0001] or [000-1] toward a second axis of <01-10>.

## Description

### BACKGROUND OF THE INVENTION

### Field of the Invention

The present invention generally relates to a semiconductor device. More specifically, the present invention relates to an SiC semiconductor device comprising p-type and n-type semiconductor layers that are adjacent to each other so as to form a pn-junction as a boundary between them, wherein the p-type and n-type semiconductor layers may have a main component of 4H-SiC.

Priority is claimed on Japanese Patent Application No. 2005-089632, filed March 25, 2005, the content of which is incorporated herein by reference.

### Description of the Related Art

All patents, patent applications, patent publications, scientific articles, and the like, which will hereinafter be cited or identified in the present application, will hereby be incorporated by reference in their entirety in order to describe more fully the state of the art to which the present invention pertains.

Recently, active research and development of high voltage and ultra-low-loss SiC semiconductor devices has been made due to the high breakdown voltage property of SiC. Typical examples of the SiC semiconductor devices may include, but are not limited to, PN diodes, P-i-N diodes and NPN transistors. A typical example of the crystal structure of SiC may include, but is not limited to, 4H-SiC, which has a hexagonal crystal structure including a plurality of periods, each of which consists of four stacked layers of SiC. "4" of 4H-SiC represents the number of stackings of SiC layers. "H" of 4H-SiC represents the hexagonal crystal structure of SiC. Other typical examples of the SiC crystal structure may include, but are not limited to, 2H-SiC, 6H-SiC and 3C-SiC. An example of the conventional 4H-SiC semiconductor device will be described.

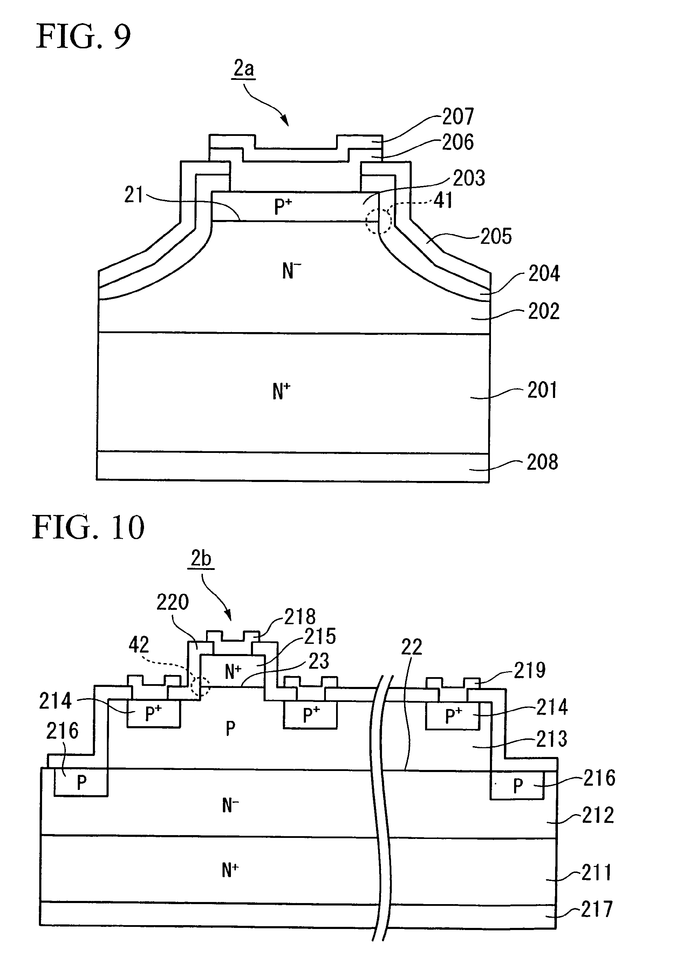

FIG 9 is a fragmentary cross sectional elevation view illustrating an example of a conventional PiN diode including a 4H-SiC substrate. A PiN diode 2a includes an N⁺-bulk layer 201 made of SiC with a high concentration of an n-type impurity. The N⁺-bulk layer 201 has first and second principal planes that are opposite each other. The PiN diode 2a further includes the following layers. An N⁻-drift layer 202 made of SiC with a low concentration of an n-type impurity is disposed on the first principal plane of the N⁺-bulk layer 201. The N⁻-drift layer 202 has a ridged structure with a flat top surface and sloped side walls. A P⁺-anode layer 203 made of SiC with a high concentration of a p-type impurity is disposed on the flat top surface of the ridged structure so as to form a pn-junction 21 at an interface between the N⁻-drift layer 202 and the P⁺-anode layer 203. The P⁺-anode layer 203 has vertical side walls and a flat top surface. The pn-junction 21 is a two dimensional boundary between the N⁻-drift layer 202 and the P⁺-anode layer 203. The pn-junction 21 has an edge 41 that is a one dimensional boundary between the side walls of the N⁻-drift layer 202 and the side walls of the P⁺-anode layer 203. A first passivation film 204 extends over the sloped side walls of the N⁻-drift layer 202 and the vertical side walls and the flat top surface of the P⁺-anode layer 203 so that the first passivation film 204 covers the edge 41 of the pn-junction 21. The first passivation film 204 is made of an insulating material such as a thermal insulating material. A second passivation film 205 extends over the first passivation film 204 so as to form a stack of the first and second passivation films 204 and 205. The stack will passivate or protect the edge 41 of the pn-junction 21. The stack has an opening which is positioned over the flat top surface of the P⁺-anode layer 203 so that a part of the flat top surface of the P⁺-anode layer 203 communicates with the opening. The opening may be formed by selectively removing a part of the stack of the first and second passivation films 204 and 205. An anode electrode 206 is disposed in the opening so as to make contact with the part of the flat top surface of the P⁺-anode layer 203. A plug electrode 207 is disposed on the anode electrode 206. A cathode electrode 208 is disposed on the second principal plane of the N⁺-bulk layer 201.

The above-described conventional PiN diode is disclosed by Camara N. at al., in "Influence of mesa wall etching on forward bias degradation in 4H-SiC pin diodes", 5th European Conference on Silicon Carbide and Related Materials (ECSCRM2004), (Italy), Trans Tech Publications Inc., Aug. 31-Sep.4, p. 560-561.

The passivation of the edge 41 of the pn-junction 21 by the stack of the first and second passivation layers 204 and 205 may be unreliable and imperfect so as to cause a large leakage of reverse current and a deterioration of current characteristics.

FIG. 10 is a fragmentary cross sectional elevation view illustrating an example of a conventional NPN transistor including a 4H-SiC substrate. An NPN transistor 2b includes an N⁺-bulk layer 211 made of SiC with a high concentration of an n-type impurity. The N⁺-bulk layer 211 has first and second principal planes that are opposite to each other. The NPN transistor 2b further includes the following layers. An N⁻-drift layer 212 made of SiC with a low concentration of an n-type impurity is disposed on the first principal plane of the N⁺-bulk layer 211. A P-base layer 213 made of SiC containing a p-type impurity is disposed on a selected region of the N⁻-drift layer 212 so as to form a pn-junction 22 at an interface between the N⁻-drift layer 212 and the P-base layer 213. The P-base layer 213 has vertical side walls and a flat top surface. The P-base layer 213 has a ridged structure with a flat top surface and a flat upper surface that surrounds the ridged structure. P⁺-base contact layers 214 with a high concentration of a p-type impurity are selectively provided in upper regions of the P-base layer 213 so that the P⁺-base contact layers 214 are distanced from the ridged structure.

An N⁺-emitter layer 215 made of SiC with a high concentration of an n-type impurity is disposed on the flat top surface of the ridged structure of the P-base layer 213 so as to form a pn-junction 23 at an interface between the P-base layer 213 and the N⁺-emitter layer 215. The N⁺-emitter layer 215 has side walls and a flat top surface. The pn-junction 23 is a two dimensional boundary between the P-base layer 213 and the N⁺-emitter layer 215. The pn-junction 23 has an edge 42 that is a one dimensional boundary between the side walls of the P-base layer 213 and the side walls of the N⁺-emitter layer 215.

A P-device terminal layer 216 is selectively formed in the N⁻-drift layer 212 so as to extend a ring shape in plan view and surround the selected region of the N⁻-drift layer 212 in plan view. A collector electrode 217 is disposed on the second principal plane of the N⁺-bulk layer 211. A passivation film 220 extends over the side walls of the N⁺-emitter layer 215, the upper surface of the P-base layer 213, and the P-device terminal layer 216 so that the passivation film 220 covers the edge 42 of the pn-junction 23. The passivation film 220 is made of an insulating material such as a thermal insulating material. The passivation film 220 will passivate or protect the edge 42 of the pn-junction 23. The passivation film 220 has an opening which is positioned over the flat top surface of the N⁺-emitter layer 215 so that a part of the flat top surface of the N⁺-emitter layer 215 communicates with the opening. The opening may be formed by selectively removing a part of the passivation film 220. An emitter electrode 218 is disposed in the opening so as to make contact with the part of the flat top surface of the N⁺-emitter layer 215.

The above-described conventional NPN transistor is disclosed by Anant K. Agarwal et al. in "Recent Progress in SiC Bipolar Junction Transistors", Proceedings of 2004 International Symposium on Power Semiconductor Devices & ICs, Institute of Electrical Engineers of Japan, p. 361-364.

The passivation of the edge 42 of the pn-junction 23 by the passivation layer 220 can be unreliable and imperfect so as to cause a high density of interface states on a semiconductor-insulator interface between the edge 42 of the pn-junction 23 and the passivation layer 220. The high density of interface states may cause a large leakage of base current, thereby reducing a current gain of the transistor and deteriorating a current characteristic thereof.

In view of the above, it will be apparent to those skilled in the art from this disclosure that there exists a need for an improved SiC semiconductor device. This invention addresses this need in the art as well as other needs, which will become apparent to those skilled in the art from this disclosure.

### SUMMARY OF THE INVENTION

Accordingly, it is a primary object of the present invention to provide a semiconductor device.

In accordance with a first aspect of the present invention, a semiconductor device comprises: a passivation film; a first semiconductor layer that has a first main component of 4H-SiC of a first conductivity type; and a second semiconductor layer that has a second main component of 4H-SiC of a second conductivity type. The second semiconductor layer has a pn-junction with the first semiconductor layer. The pn-junction has a junction edge. The first and second semiconductor layers further include a local area that includes the junction edge. The local area has a first principal plane that interfaces with the passivation film. A normal to the first principal plane tilts by a first tilt angle in a range of 25 degrees to 45 degrees from a first axis of [0001] or [000-1] toward a second axis of <01-10>.

Preferably, the first tilt angle is in a range of 30 degrees to 39 degrees.

More preferably, the first tilt angle is 35.3 degrees and the first principal plane is a {03-38} plane.

Preferably, the pn-junction may be distanced from a cross of the first principal plane and a second plane that is perpendicular to a third axis that tilts by a second tilt angle of less than 25 degrees or more than 45 degrees from the first axis of [0001] or [000-1] toward the second axis of <01-10>.

Preferably, the passivation film may comprise an insulation film so as to form a semiconductor-insulator interface with the first principal plane.

Preferably, the first and second semiconductor layers may have a sloped side wall that includes the local area, and the sloped side wall has the first principal plane and a semiconductor-insulator interface with the passivation film.

Preferably, the first and second semiconductor layers may have a ridged structure that has sloped side walls and the pn-junction, and at least one of the sloped side walls includes the local area and comprises the first principal plane that interfaces with the passivation film.

In accordance with a second aspect of the present invention, a semiconductor device comprises: a ridged structure that has a sloped side wall that includes a local area having a first principal plane; and a passivation film that interfaces with the first principal plane. The ridged structure further comprises: a first semiconductor layer that has a first main component of 4H-SiC of a first conductivity type; and a second semiconductor layer that has a second main component of 4H-SiC of a second conductivity type. The second semiconductor layer has a pn-junction with the first semiconductor layer. The pn-junction has a junction edge that is positioned on the local area. A normal to the first principal plane tilts by a first tilt angle in a range of 25 degrees to 45 degrees from a first axis of [0001] or [000-1] toward a second axis of <01-10>.

Preferably, the first tilt angle is in a range of 30 degrees to 39 degrees. More preferably, the first tilt angle is 35.3 degrees and the first principal plane is a {03-38} plane.

Preferably, the pn-junction is distanced from a cross of the first principal plane and a second plane that is perpendicular to a third axis that tilts by a second tilt angle of less than 25 degrees or more than 45 degrees from the first axis of [0001] or [000-1] toward the second axis of <01-10>.

Preferably, the passivation film comprises an insulation film so as to form a semiconductor-insulator interface with the first principal plane.

These and other objects, features, aspects, and advantages of the present invention will become apparent to those skilled in the art from the following detailed descriptions taken in conjunction with the accompanying drawings, illustrating the embodiments of the present invention.

### BRIEF DESCRIPTION OF THE DRAWINGS

Referring now to the attached drawings which form a part of this original disclosure:
FIG 1 is a fragmentary cross sectional elevation view illustrating a 4H-SiC semiconductor device in accordance with a first preferred embodiment of the present invention;
FIG. 2 is a diagram showing a calculated result of a variation of the number of dangling bonds per unit area over the tilt angle by which the normal to a plane of 4H-SiC tilts from a <0001> direction toward a <01-10> or <11-20> direction, wherein the dangling bounds are present on the plane;
FIGS. 3A through 3C are fragmentary cross sectional elevation views illustrating sequential steps involved in a method of forming the semiconductor device of FIG 1;
FIG. 4 is a fragmentary cross sectional elevation view illustrating a 4H-SiC semiconductor device in accordance with a second preferred embodiment of the present invention;
FIGS. 5A through 5E are fragmentary cross sectional elevation views illustrating sequential steps involved in a method of forming the semiconductor device of FIG. 4;
FIG. 6 is a fragmentary cross sectional elevation view illustrating one of a plurality of unit cells of a 4H-SiC semiconductor device in accordance with a third preferred embodiment of the present invention;
FIG. 7 is a fragmentary plan view in a direction of [000-1] illustrating the semiconductor device of FIG. 6;
FIGS. 8A through 8E are fragmentary cross sectional elevation views illustrating sequential steps involved in a method of forming the semiconductor device of FIG. 6;
FIG. 9 is a fragmentary cross sectional elevation view illustrating an example of a conventional PiN diode including a 4H-SiC substrate; and
FIG. 10 is a fragmentary cross sectional elevation view illustrating an example of a conventional NPN transistor including a 4H-SiC substrate.

### DETAILED DESCRIPTION OF THE INVENTION

Selected embodiments of the present invention will now be described with reference to the drawings. It will be apparent to those skilled in the art from this disclosure that the following descriptions of the embodiments of the present invention are provided for illustration only and not for the purpose of limiting the invention as defined by the appended claims and their equivalents.

The present invention will be described with reference to the technical term "crystal axis" that is presented by the Miller index of crystallography. The present invention provides a semiconductor device which comprises 4H-SiC having a hexagonal crystal structure including a plurality of periods, each of which consists of four stacked layers of SiC. The semiconductor device includes a base layer, a bulk layer or a substrate that is made of 4H-SiC and has a principal plane. The direction vertical to the principal plane is parallel to a crystal axis of [0001] or [000-1]. The crystal axis of [0001] is the normal to a (0001) plane. The crystal axis of [000-1] is the normal to a (000-1) plane. The 4H-SiC layer or substrate has a principal plane of (0001) or (000-1). The mark < > represents a family of crystal axes that are equivalent to each other. For example, a <01-10> axis is equivalent to a [01-10] axis, [0-110] axis, [1-100] axis, [-1100] axis, [10-10] axis and [-1010] axis. The mark { } represents a family of crystal planes that are equivalent to each other. For example, a {0001} plane is equivalent to a (0001) plane and a (000-1) plane. In the specification, claims, abstract and drawings of the present application, the mark "-" in [],(),<>, and {} means "bar" positioned over the number of the Miller index. For example, [000-1] means [0001bar].

### First Embodiment:

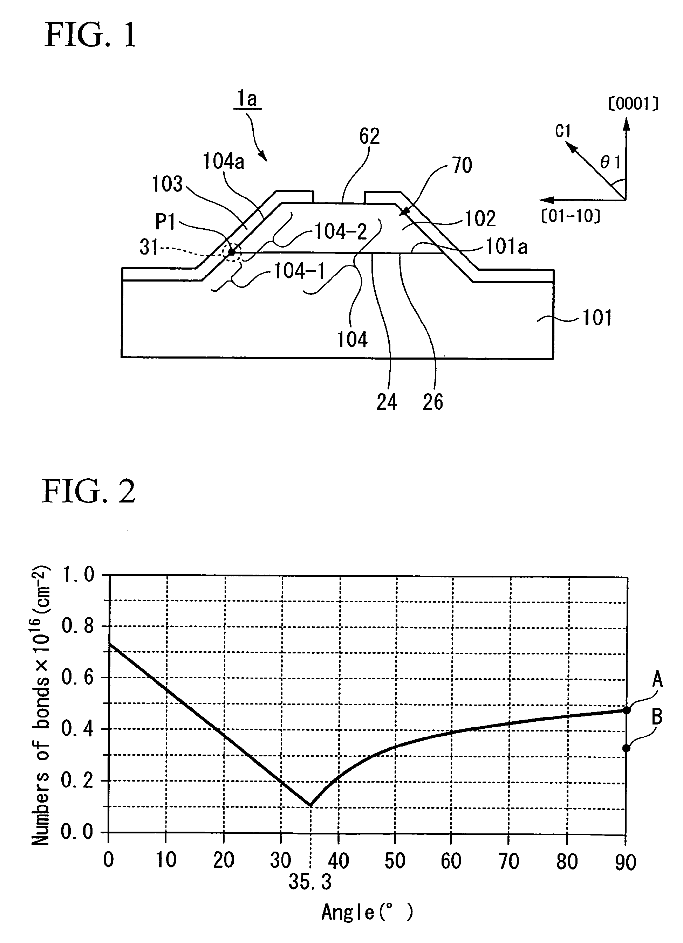

A first preferred embodiment of the present invention will be described. FIG. 1 is a fragmentary cross sectional elevation view illustrating a 4H-SiC semiconductor device in accordance with a first preferred embodiment of the present invention. The first preferred embodiment provides a 4H-SiC semiconductor device 1a that acts as a PN-diode. The 4H-SiC semiconductor device 1a has a stack that comprises first and second conductive layers 101 and 102 that are adjacent to each other. The first conductive layer 101 has a main component of 4H-SiC that contains an n-type impurity. The second conductive layer 102 has a main component of 4H-SiC that contains a p-type impurity. The second conductive layer 102 is disposed on a first principal plane 101a of the first conductive layer 101 so as to form an interface 24 between the first and second conductive layers 101 and 102. The interface 24 also forms a pn-junction 26.

The stack of the first and second conductive layers 101 and 102 includes a ridged structure 70 that has sloped side walls 104 and a flat top surface 62. The first conductive layer 101 has a base portion and a ridged portion that is formed over the base portion. The base portion has a flat upper surface. The ridged portion has the first principal plane 101a and first sloped side walls 104-1. The second conductive layer 102 has second sloped side walls 104-2 and the flat top surface 62. Thus, the ridged structure 70 comprises the second conductive layer 102 and the ridged portion of the first conductive layer 101. At least one of the sloped side walls 104 comprises the combined first and second sloped side walls 104-1 and 104-2 that are aligned to each other. The sloped side walls 104 tilt from the interface 24. The pn-junction 26 has an edge P1 that is positioned at a boundary between the first and second sloped side walls 104-1 and 104-2. Namely, the edge P1 of the pn-junction 26 is positioned on the sloped side wall 104.

A passivation film 103 extends over the sloped side walls 104, a part of the flat top surface 62 and the flat upper surface of the base portion. The passivation film 103 covers the sloped side walls 104 that include the edge P1 of the pn-junction 26. The passivation film 103 is provided in order to passivate or protect the pn-junction 26. Therefore, the passivation film 103 passivates or protects at least the edge P1 of the pn-junction 26. The sloped side wall 104 includes a local area 31 that further includes the edge P1 of the pn-junction 26. Thus, the passivation film 103 may typically cover the local area 31 of the sloped side wall 104 so as to passivate or protect at least the edge P 1 of the pn-junction 26. The passivation film 103 is made of an insulator such as a thermal insulating material.

The first principal plane 101a is vertical to a crystal axis of [0001]. The first principal plane 101a is parallel to another crystal axis of [01-10] that is perpendicular to the crystal axis of [0001]. The first principal plane 101a is a (0001) plane. The side wall 104 has a principal plane 104a that is vertical to a C1-axis that tilts by a tilt angle θ 1 from the crystal axis of [0001] toward the crystal axis of [01-10]. The tilt angle θ 1 is preferably in a range of 25 degrees to 45 degrees, and more preferably in a range of 30 degrees to 39 degrees, and optimally 35.3 degrees. When the tilt angle θ 1 is 35.3 degrees, the principal plane 104a is a (03-38) plane of hexagonal crystal. The (03-38) plane of hexagonal crystal corresponds to a (001) plane of cubic crystal. When an insulating layer is adjacent to the (03-38) plane of the hexagonal crystal of the SiC semiconductor, an insulator-semiconductor interface between the insulating layer and the (03-38) plane of the hexagonal crystal has a lowest density of interface states. The tilt angle θ 1 may vary depending on erroneous variations of the manufacturing conditions. Thus, it is extremely preferable for the tilt angle θ 1 to be in a range of 34 degrees to 36 degrees.

The ridged structure 70 has the sloped side walls 104, at least one of which has the local area 31 that includes the edge P1 of the pn-junction 26. The passivation film 103 covers at least the local area 31 in order to protect or passivate the pn-junction 26. The local area 31 comprises the edge P1 and adjacent areas thereto. In order to reduce the density of interface states between the local area 31 and the passivation film 103, it is preferable for the local area 31 to have a principal plane that is normal or perpendicular to the C1-axis that tilts by the tilt angle θ 1 from the crystal axis of [0001] toward the crystal axis of [01-10], wherein the tilt angle θ 1 satisfies the above-described condition.

Microscopically, the local area 31 has a principal plane that is vertical to the C1-axis tilting by the tilt angle θ 1 from the crystal axis of [0001] toward the crystal axis of [01-10]. The tilt angle θ1 is preferably in a range of 25 degrees to 45 degrees. The local area 31 means a small area that forms the principal plane that includes the edge P 1 of the pn-junction 26. Thus, the local area 31 may include not only the edge P1 of the pn-junction 26 but also a peripheral area that surrounds the edge P1. The sloped side wall 104 may have a surface roughness. However, if the sloped side wall 104 has a roughness-free surface, the principal plane 104a of the sloped side wall 104 is identical with the principal plane of the local area 31. Macroscopically, the principal plane 104a of the sloped side wall 104 is identical with the principal plane of the local area 31, regardless of the surface roughness.

Alternatively, the principal plane 101 a of the first conductive layer 101 may be a (000-1) plane. The principal plane 104a of the sloped side wall 104 is normal or perpendicular to the C1-axis that may tilt by the tilt angle θ 1 from the crystal axis of [000-1] toward the crystal axis of [01-10] or its equivalent.

Namely, the principal plane 104a is normal or perpendicular to the C1-axis that tilts by the tilt angle θ 1 in the range of 25 degrees to 45 degrees from the crystal axis of [0001] or [000-1] toward a <01-10> direction. When the tilt angle θ 1 is 35.3 degrees, the C1 axis is normal to a {03-38} plane.

First and second planes are now given. The first plane is normal or perpendicular to a first axis that tilts by a first tilt angle from the axis of [0001] or [000-1] toward the <01-10> direction, wherein the first tilt angle is less than 25 degrees or more than 45 degrees. The second plane is normal or perpendicular to a second axis that tilts by a second tilt angle from the axis of [0001] or [000-1] toward the <01-10> direction, wherein the second tilt angle is at least 25 degrees and at most 45 degrees. A typical example of the second plane may include, but is not limited to, the above-described principal plane 104a. The first and second planes cross each other at a cross. The edge P1 of the pn-junction 26 on the interface 24 may preferably be distanced from the cross of the first and second planes.

The following descriptions will focus on the reason why the above-described tilt angle θ 1 is preferably in the range of 25 degrees to 45 degrees. FIG. 2 is a diagram showing a calculated result of a variation of the number of dangling bonds per unit area over the tilt angle by which the normal to a plane of 4H-SiC tilts from a <01-10> direction toward a <01-10> or < 11-20> direction, wherein the dangling bounds are present on the plane. When the tilt angle is 90 degrees, the plane of 4H-SiC is a {01-10} or {11-20} plane.

As shown in FIG. 2, as the tilt angle increases from 0 degree to 35.3 degrees, the number of dangling bonds simply decreases. As the tilt angle increases from 35.3 degrees to 90 degrees, the number of dangling bonds simply increases. Namely, the number of dangling bonds has a minimum value at the tilt angle of 35.3 degrees. The principal plane that includes the edge of the pn-junction is the {01-10} or {11-20} plane. The mark "A" represents the number of dangling bonds on the {01-10} plane. The mark "B" represents the number of dangling bonds on the {11-20} plane.

Decreasing the number of dangling bonds per unit area decreases the density of interface states, thereby decreasing the leakage of current. In order to reduce the leakage of current, it is preferable for the number of dangling bonds per unit area to be not more than 0.3E16 (cm⁻²), and thus the tilt angle is in a range of 25 degrees to 45 degrees. More preferably, the number of dangling bonds per unit area is not more than 0.2E 16 (cm⁻²), and thus the tilt angle is in a range of 30 degrees to 39 degrees. The optimum tilt angle is 35.3 degrees to minimize the number of dangling bonds.

As described above, the semiconductor 1a includes the stack of the first and second conductive layers 101 and 102 that are adjacent to each other. The stack has the ridged structure 70 that has the flat top surface 62 and the sloped side walls 104, and includes the pn-junction 26 on the interface 24 between the first and second conductive layers 101 and 102. The pn-junction 26 has the edge P1 that is the one dimensional boundary between the first and second sloped side walls 104-1 and 104-2 of the first and second conductive layers 101 and 102. At least one of the sloped side walls 104 includes the local area 31 that further includes the edge P1 of the pn-junction 26. Macroscopically, at least one of the sloped side walls 104 has the principal plane that is normal or perpendicular to the C1-axis tilting by the tilt angle θ 1 in the range of 25 degrees to 45 degrees from the crystal axis of [0001] or [000-1] toward the <01-10> direction. Microscopically, the local area 31 including the edge P1 of the pn-junction 26 has the principal plane that is normal or perpendicular to the C1-axis tilting by the tilt angle θ 1 in the range of 25 degrees to 45 degrees from the crystal axis of [0001] or [000-1] toward the <01-10> direction. The local area 31 is in contact with the passivation film 103 so as to form an interface between the local area 31 made of SiC and the passivation film 103 made of an insulator. The limited range of the tilt angle θ 1 defining the normal to the principal plane of the local area 31 provides the reduced density of dangling bonds that are present on the interface between the local area 31 and the passivation film 103. The reduced density of dangling bonds reduces the density of interface states on the interface between the local area 31 and the passivation film 103, thereby reducing the leakage of reverse current through the pn-junction 26 and providing the improved current characteristics.

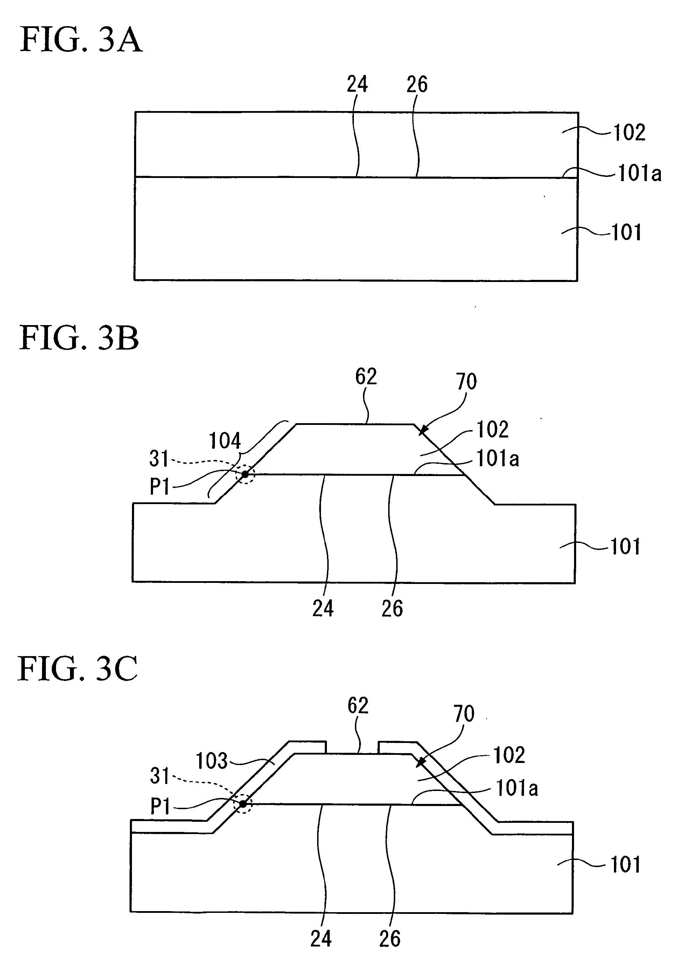

A method of forming the above-described semiconductor device 1a will be described. FIGS. 3A through 3C are fragmentary cross sectional elevation views illustrating sequential steps involved in a method of forming the semiconductor device of FIG. 1.

As shown in FIG. 3A, the first conductive layer 101 ofn-SiC as a substrate is prepared. The first conductive layer 101 has the principal plane 101a. The second conductive layer 102 of p-SiC is formed on the principal plane 101 a of the first conductive layer 101 by an available deposition method such as a CVD (Chemical Vapor Deposition) method, thereby forming the interface 24 between the first and second conductive layers 101 and 102. The interface 24 has the pn-junction 26. A chemical mechanical polishing process may optionally and preferably be carried out to the principal plane 101 a before the second conductive layer 102 is deposited on the principal plane 101a. Alternatively, the second conductive layer 102 may be formed by introducing a p-type impurity such as Al or B into the principal plane 101a of the first conductive layer 101 by an ion implantation.

As shown in FIG. 3B, an etching mask that is not illustrated is formed on an upper surface of the second conductive layer 102. The etching mask has a pattern that includes windows. The stack of the first and second conductive layers 101 and 102 with the etching mask is placed in a dry etching chamber in order to carry out a dry etching process under the following conditions. A mixed gas of CF₄ and O₂ may be used as an etching gas. A ratio of an O₂ flow rate to a total flow rate of CF₄ and O₂ is in a range of about 10% to about 90%. Alternatively, another mixed gas of CHF, CF₆ or CF₃ and O₂ may be used.

After the mixed gas is introduced to a space around an induction coil in the dry etching chamber, then a high frequency power of 2.45GHz at a power of 200W-1000W is applied to the induction coil so as to generate CF₄ and O₂ plasmas. A microwave of 2.45GHz is preferable in order to generate a high density plasma. Alternatively, a radio wave of 13.56MHz can be used. It is effective to enhance the anisotropy of the etching process in order to obtain a high aspect ratio of an etched structure. To enhance the anisotropy, it is effective to apply a high voltage such as 1000V to a sample stage on which a sample to be etched is placed so that positively charged plasmas are actively irradiated onto the sample. The etching process forms the ridged structure 70 that has the sloped side walls 104 and the flat top surface 62. The sloped side walls 104 are etching surfaces that tilt from the principal plane 101a of the first conductive layer 101. The voltage to be applied to the sample stage may be adjusted in the range of approximately 0V to approximately 500V, preferably less than 300V and more preferably less than 200V, so that macroscopically at least one of the sloped side walls 104 has the principal plane that is normal or perpendicular to the axis tilting by the tilt angle θ 1 in the range of 25 degrees to 45 degrees from the crystal axis of [0001] toward the crystal axis of [01-10]. Defining the ridged portion 70 by the etching process defines the edge P1 of the pn-junction 26 on the interface between the first and second conductive layers 101 and 102. Microscopically, at least one of the sloped side walls 104 includes the local area 31 that further includes the edge P1 of the pn-junction 26, wherein the local area 31 has the principal plane that is normal or perpendicular to the C1-axis tilting by the tilt angle θ 1 in the range of 25 degrees to 45 degrees from the crystal axis of [0001] toward the crystal axis of [01-10].

As shown in FIG. 3C, a passivation film 103 is formed so as to extend over the sloped side walls 104, the flat top surface 62 and the flat upper surface of the base portion. The passivation film 103 is patterned to form an opening to which a part of the flat top surface 62 is exposed. The passivation film 103 is made of an insulating material such as a thermal insulating material. The passivation film 103 covers the sloped side walls 104 that include the edge P1 of the pn-junction 26 so as to passivate or protect the edge P1 of the pn-junction 26. The passivation film 103 may be deposited by a CVD (Chemical Vapor Deposition) method. The passivation film 103 may be formed by a thermal oxidation process. Typical examples of a gas to be used in the thermal oxidation process may include, but are not limited to, O₂, N₂O and NO. A typical example of a temperature range of the thermal oxidation process may be, but is not limited to, a range of 900°C to 1400°C. A preferable example of the temperature can depend on the limitation of the production and the conditions for formation of the insulating film that further depends on the kind of gas. The passivation film 103 is completed thereby completing the semiconductor device 1a.

As described above, macroscopically, at least one of the sloped side walls 104 has the principal plane that is normal or perpendicular to the C1-axis tilting by the tilt angle θ 1 in the range of 25 degrees to 45 degrees from the crystal axis of [0001] or [000-1] toward the <01-10> direction. Microscopically, the local area 31 including the edge P1 of the pn-junction 26 has the principal plane that is normal or perpendicular to the C1-axis tilting by the tilt angle θ 1 in the range of 25 degrees to 45 degrees from the crystal axis of [0001] or [000-1] toward the <01-10> direction. The local area 31 is in contact with the passivation film 103 so as to form an interface between the local area 31 made of SiC and the passivation film 103 made of an insulator. The limited range of the tilt angle θ 1 defining the normal to the principal plane of the local area 31 provides the reduced density of dangling bonds that are present on the interface between the local area 31 and the passivation film 103. The reduced density of dangling bonds reduces the density of interface states on the interface between the local area 31 and the passivation film 103, thereby reducing the leakage of reverse current through the pn-junction 26 and providing the improved current characteristics.

### Second Embodiment:

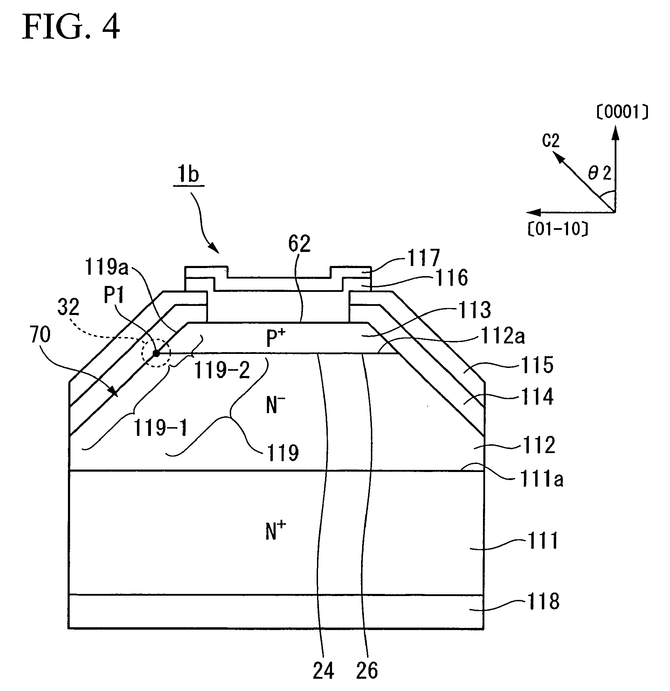

A second preferred embodiment of the present invention will be described. FIG. 4 is a fragmentary cross sectional elevation view illustrating a 4H-SiC semiconductor device in accordance with a second preferred embodiment of the present invention. The second preferred embodiment provides a 4H-SiC semiconductor device 1b that acts as a PiN-diode. The 4H-SiC semiconductor device 1b has a stack that comprises an N⁺-bulk layer 111, an N⁻-drift layer 112 and a P⁺-anode layer 113. The N⁺-bulk layer 111 has a main component of 4H-SiC that has a high concentration of an n-type impurity. The N⁺-bulk layer 111 serves as an n-SiC substrate. The N⁺-bulk layer 111 has a principal plane 111a. The N⁻-drift layer 112 is disposed on the principal plane 111a of the N⁺-bulk layer 111. The N⁻-drift layer 112 has a main component of 4H-SiC that has a low concentration of an n-type impurity. The N⁻-drift layer 112 is lower in the impurity concentration and the electrical conductivity than the N⁺-bulk layer 111. The N⁻-drift layer 112 has a principal plane 112a. The P⁺-anode layer 113 is disposed on the principal plane 112a of the N⁻-drift layer 112 so as to form an interface 24 between the N⁻-drift layer 112 and the P⁺-anode layer 113. The interface 24 also forms a pn-junction 26. As compared to the N⁻-drift layer 112, the N⁺-bulk layer 111 has a high conductivity and a low resistivity so as to reduce a series resistance of the semiconductor device 1b. As compared to the N⁺-bulk layer 111, the N⁻-drift layer 112 has a low conductivity and a high resistivity so as to improve a withstand voltage characteristic of the semiconductor device 1b. The thickness and the impurity concentration of the N⁻-drift layer 112 may be decided so as to ensure a required withstand voltage characteristic.

The stack of the N⁻-drift layer 112 and the P⁺-anode layer 113 includes a ridged structure 70 that has sloped side walls 119 and a flat top surface 62. The N⁻-drift layer 112 has a base portion and a ridged portion that is formed over the base portion. The base portion has vertical side walls. The ridged portion has the principal plane 112a and first sloped side walls 119-1. The P⁺-anode layer 113 has second sloped side walls 119-2 and the flat top surface 62. Thus, the ridged structure 70 comprises the P⁺-anode layer 113 and the ridged potion of the N⁻-drift layer 112. At least one of the sloped side walls 119 comprises the combined first and second sloped side walls 119-1 and 119-2 that are aligned to each other. The sloped side walls 119 tilt from the interface 24. The pn-junction 26 has an edge P1 that is positioned at a boundary between the first and second sloped side walls 119-1 and 119-2. Namely, the edge P1 of the pn-junction 26 is positioned on at least one of the sloped side walls 119.

A first passivation film 114 extends over the sloped side walls 119 and a part of the flat top surface 62. The first passivation film 114 covers the sloped side walls 119 that include the edge P1 of the pn-junction 26. A second passivation film 115 extends over the first passivation film 114. A stack of the first and second passivation films 114 and 115 covers the sloped side walls 119 that include the edge P1 of the pn-junction 26. The stack is provided in order to passivate or protect the pn-junction 26. Therefore, the stack of the first and second passivation films 114 and 115 passivates or protects at least the edge P1 of the pn-junction 26. At least one of the sloped side walls 119 includes a local area 32 that further includes the edge P1 of the pn-junction 26. Thus, the stack of the first and second passivation films 114 and 115 may typically cover the local area 32 of the sloped side wall 119 so as to passivate or protect at least the edge P1 of the pn-junction 26. The first passivation film 114 is made of an insulator such as thermal oxynitride. The second passivation film 115 is made of an insulator such as nitride.

The stack of the first and second passivation films 114 and 115 extends in a ring shape so as to surround the N⁻-drift layer 112 in plan view or a direction vertical to the (0001) plane.

The stack of the first and second passivation films 114 and 115 has an opening which is positioned over the flat top surface 62 of the P⁺-anode layer 113. An anode electrode 116 is provided in the opening so that the anode electrode 116 has an ohmic contact with the flat top surface 62 of the P⁺-anode layer 113. The anode electrode 116 may be formed as follows. A titanium (Ti) layer is deposited on the exposed portion of the flat top surface 62 of the P⁺-anode layer 113 and the second passivation film 115. An aluminum (Al) layer is further deposited on the titanium (Ti) layer to form a lamination of the titanium (Ti) layer and the aluminum (Al) layer before an annealing process is carried out at a temperature of not lower than 900°C to form the anode electrode 116. A plug electrode 117 is disposed on the anode electrode 116. The plug electrode 117 may be made of a conductive material such as Al, Ni, or Au.

The N⁺-bulk layer 111 has another plane opposite to the principal plane 111a. A cathode electrode 118 is disposed on the opposite plane of the N⁺-bulk layer 111 so that the cathode electrode 118 has an ohmic contact with the N⁺-bulk layer 111. The cathode electrode 118 may be formed as follows. A nickel (Ni) layer is deposited on the opposite plane of the N⁺-bulk layer 111 before an annealing process is carried out at a temperature of not lower than 900°C to form the cathode electrode 118.

The principal plane 111 a of the N⁺-bulk layer 111 is vertical to a crystal axis of [0001]. The principal plane 111a is parallel to another crystal axis of [01-10] that is perpendicular to the crystal axis of [0001]. The principal plane 111a is a (0001) plane. The side wall 119 has a principal plane 119a that is vertical to a C2-axis that tilts by a tilt angle θ 2 from the crystal axis of [0001] toward the crystal axis of [01-10]. The tilt angle θ 2 is preferably in a range of 25 degrees to 45 degrees, and more preferably in a range of 30 degrees to 39 degrees, and optimally 35.3 degrees. When the tilt angle θ 2 is 35.3 degrees, the principal plane 119a is a (03-38) plane of hexagonal crystal. The (03-38) plane of hexagonal crystal corresponds to a (001) plane of cubic crystal. When an insulating layer is adjacent to the (03-38) plane of the hexagonal crystal of the SiC semiconductor, an insulator-semiconductor interface between the insulating layer and the (03-38) plane of the hexagonal crystal has a lowest density of interface states. The tilt angle θ 2 may vary depending on erroneous variations of the manufacturing conditions. Thus, it is extremely preferable for the tilt angle θ 2 to be in a range of 34 degrees to 36 degrees.

The ridged structure 70 has the sloped side walls 119, at least one of which has the local area 32 that includes the edge P1 of the pn-junction 26. The stack of the first and second passivation films 114 and 115 covers at least the local area 32 in order to protect or passivate the pn-junction 26. The local area 32 comprises the edge P1 and adjacent areas thereto. In order to reduce the density of interface states between the local area 32 and the stack of the first and second passivation films 114 and 115, it is preferable for the local area 32 to have a principal plane that is normal or perpendicular to the C2-axis that tilts by the tilt angle θ 2 from the crystal axis of [0001] toward the crystal axis of [01-10], wherein the tilt angle θ 2 satisfies the above-described condition.

Microscopically, the local area 32 has a principal plane that is vertical to the C2-axis tilting by the tilt angle θ 2 from the crystal axis of [0001] toward the crystal axis of [01-10]. The tilt angle θ 2 is preferably in a range of 25 degrees to 45 degrees. The local area 32 means a small area that forms the principal plane that includes the edge P 1 of the pn-junction 26. Thus, the local area 32 may include not only the edge P1 of the pn-junction 26 but also a peripheral area that surrounds the edge P1. At least one of the sloped side walls 119 may have a surface roughness. However, if at least one of the sloped side walls 119 has a roughness-free surface, the principal plane 119a of at least one of the sloped side walls 119 is identical with the principal plane of the local area 32. Macroscopically, the principal plane 119a of at least one of the sloped side walls 119 is identical with the principal plane of the local area 32, regardless of the surface roughness.

Alternatively, the principal plane 111 a of the N⁺-bulk layer 111 may be a (000-1) plane. The principal plane 119a of at least one of the sloped side walls 119 is normal or perpendicular to the C2-axis that may tilt by the tilt angle θ 2 from the crystal axis of [000-1] toward the crystal axis of [01-10] or its equivalent.

Namely, the principal plane 119a is normal or perpendicular to the C2-axis that tilts by the tilt angle θ 2 in the range of 25 degrees to 45 degrees from the crystal axis of [0001] or [000-1] toward a <01-10> direction. When the tilt angle θ 2 is 35.3 degrees, the C2-axis is normal to a {03-38} plane.

The reason the above-described tilt angle θ 2 is preferably in the range of 25 degrees to 45 degrees is the same as described above with reference to FIG. 2. Duplicate descriptions will thus be omitted.

Decreasing the number of dangling bonds per unit area decreases the density of interface states, thereby decreasing the leakage of current. In order to reduce the leakage of current, it is preferable for the number of dangling bonds per unit area to be not more than 0.3E16 (cm⁻²), and thus the tilt angle is in a range of 25 degrees to 45 degrees. More preferably, the number of dangling bonds per unit area is not more than 0.2E16 (cm⁻²), and thus the tilt angle is in a range of 30 degrees to 39 degrees. The optimum tilt angle is 35.3 degrees to minimize the number of dangling bonds.

As described above, the semiconductor 1b includes the stack of the N⁻-drift layer 112 and the P⁺-anode layer 113 that are adjacent to each other. The stack has the ridged structure 70 that has the flat top surface 62 and the sloped side walls 119, and includes the pn-junction 26 on the interface 24 between the N⁻-drift layer 112 and the P⁺-anode layer 113. The pn-junction 26 has the edge P1 that is the one dimensional boundary between the first and second sloped side walls 119-1 and 119-2 of the N⁻-drift layer 112 and the P⁺-anode layer 113. At least one of the sloped side walls 119 includes the local area 32 that further includes the edge P1 of the pn-junction 26. Macroscopically, at least one of the sloped side walls 119 has the principal plane that is normal or perpendicular to the C2-axis tilting by the tilt angle θ2 in the range of 25 degrees to 45 degrees from the crystal axis of [0001] or [000-1] toward the <01-10> direction. Microscopically, the local area 32 including the edge P1 of the pn-junction 26 has the principal plane that is normal or perpendicular to the C2-axis tilting by the tilt angle θ 2 in the range of 25 degrees to 45 degrees from the crystal axis of [0001] or [000-1] toward the <01-10> direction. The local area 32 is in contact with the first passivation film 114 so as to form an interface between the local area 32 made of SiC and the first passivation film 114 made of an insulator. The limited range of the tilt angle θ 2 defining the normal to the principal plane of the local area 32 provides the reduced density of dangling bonds that are present on the interface between the local area 32 and the first passivation film 114. The reduced density of dangling bonds reduces the density of interface states on the interface between the local area 32 and the first passivation film 114, thereby reducing the leakage of reverse current through the pn-junction 26 and providing the improved current characteristics.

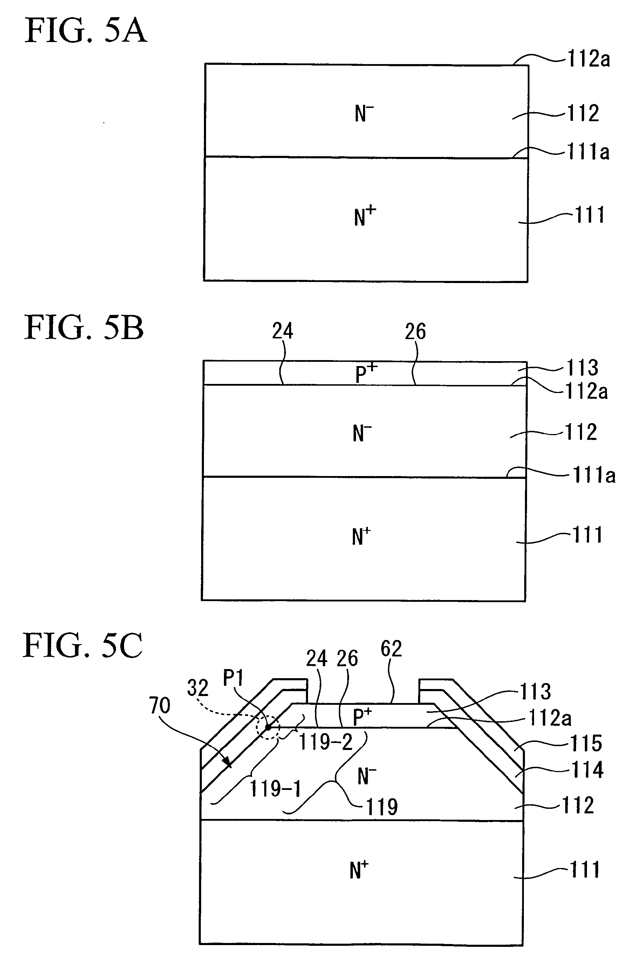

A method of forming the above-described semiconductor device 1b will be described. FIGS. 5A through 5E are fragmentary cross sectional elevation views illustrating sequential steps involved in a method of forming the semiconductor device of FIG. 4.

As shown in FIG. 5A, the N⁺-bulk layer 111 as a substrate is prepared. The N⁺-bulk layer 111 has the principal plane 111a. The N⁻-drift layer 112 is deposited on the principal plane 111a of the N⁺-bulk layer 111 by an available deposition method such as a CVD (Chemical Vapor Deposition) method. The N⁻-drift layer 112 has the principal plane 112a. As compared to the N⁻-drift layer 112, the N⁺-bulk layer 111 has a high conductivity and a low resistivity so as to reduce a series resistance of the semiconductor device 1b. As compared to the N⁺-bulk layer 111, the N⁻-drift layer 112 has a low conductivity and a high resistivity so as to improve a withstand voltage characteristic of the semiconductor device 1b. The thickness and the impurity concentration of the N⁻-drift layer 112 may be decided so as to ensure a required withstand voltage characteristic.

As shown in FIG. 5B, the P⁺-anode layer 113 is deposited on the principal plane 112a of the N⁻-drift layer 112 by an available deposition method such as a CVD (Chemical Vapor Deposition) method, thereby forming the interface 24 between the N⁻-drift layer 112 and the P⁺-anode layer 113. The interface 24 has the pn-junction 26. Alternatively, the P⁺-anode layer 113 may be formed by introducing a p-type impurity such as Al or B into the principal plane 112a of the N⁻-drift layer 112 by an ion implantation and then annealing at a temperature of not lower than 1500°C.

As shown in FIG. 5C, an etching mask that is not illustrated is formed on an upper surface of the P⁺-anode layer 113. The etching mask has a pattern that includes windows. The stack of the N⁺-bulk layer 111, the N⁻-drift layer 112 and the P⁺-anode layer 113 with the etching mask is placed in a dry etching chamber in order to carry out a dry etching process under the following conditions. The etching gas similar to that of the first embodiment can be used.

The etching process can also be carried out in the similar conditions to those of the first embodiment so as to form the ridged structure 70 that has the sloped side walls 119 and the flat top surface 62. The voltage to be applied to the sample stage is adjusted so that macroscopically at least one of the sloped side walls 119 has the principal plane that is normal or perpendicular to the axis tilting by the tilt angle θ 2 in the range of 25 degrees to 45 degrees from the crystal axis of [0001] toward the crystal axis of [01-10]. Defining the ridged portion 70 by the etching process defines the edge P1 of the pn-junction 26 on the interface between the first and second conductive layers 101 and 102. Microscopically, at least one of the sloped side walls 119 includes the local area 32 that further includes the edge P1 of the pn-junction 26, wherein the local area 32 has the principal plane that is normal or perpendicular to the C2-axis tilting by the tilt angle θ 2 in the range of 25 degrees to 45 degrees from the crystal axis of [0001] toward the crystal axis of [01-10].

The first passivation film 114 is formed so as to extend over the sloped side walls 119 and the flat top surface 62 of the P⁺-anode layer 113. The first passivation film 114 covers the sloped side walls 119 that include the edge P1 of the pn-junction 26 so as to passivate or protect the edge P1 of the pn-junction 26. The first passivation film 114 may be grown by forming a thermal oxynitride film at a temperature of about 1200°C and using N₂O gas. The second passivation film 115 made of nitride is deposited on the first passivation film 114 by a CVD (Chemical Vapor Deposition) method, thereby forming a stack of the first and second passivation films 114 and 115 that passivate and protect the pn-junction 26. A part of the stack of the first and second passivation films 114 and 115 is then exposed to an acid solution so as to form an opening that penetrates the stack so that a part of the flat top surface 62 is exposed to the opening. The second passivation film 115 protects the first passivation film 114 from the acid solution except over the flat top surface 62.

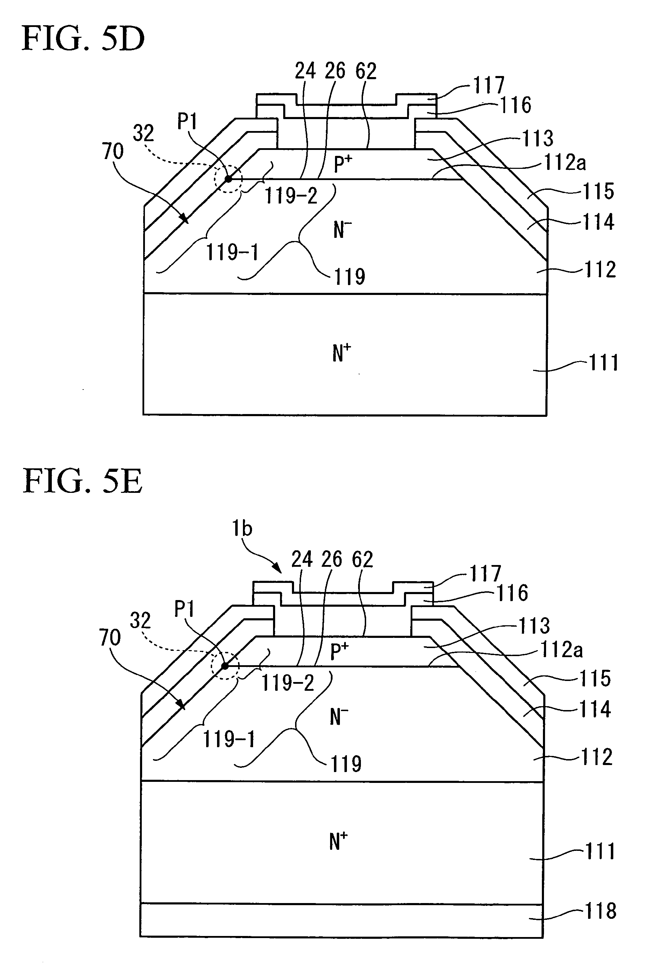

As shown in FIG. 5D, the anode electrode 116 can be formed as follows. A titanium (Ti) layer is deposited on the second passivation film 115 and the exposed portion of the flat top surface 62 of the P⁺-anode layer 113. An aluminum (Al) layer is further deposited on the titanium (Ti) layer to form a lamination of the titanium (Ti) layer and the aluminum (Al) layer. The lamination of the titanium (Ti) layer and the aluminum (Al) layer is selectively removed by using an acid solution to leave the lamination in the opening and on the exposed portion of the flat top surface 62, thereby forming the anode electrode 116. The plug electrode 117 can also be formed as follows. An aluminum (Al) layer is deposited on the second passivation film 115 and the titanium (Ti) layer by a deposition method. The aluminum (Al) layer is then selectively removed using an acid solution to leave the aluminum (Al) layer over the anode electrode 116, thereby forming the plug electrode 117.

As shown in FIG. 5E, the cathode electrode 118 is disposed on the opposite plane of the N⁺-bulk layer 111 by a deposition method. The cathode electrode 118 may be formed as follows. A nickel (Ni) layer is deposited on the opposite plane of the N⁺-bulk layer 111 before an annealing process is carried out at a temperature of not lower than 900°C to form the cathode electrode 118, thereby completing the semiconductor device 1b.

As described above, macroscopically, at least one of the sloped side walls 119 has the principal plane that is normal or perpendicular to the C2-axis tilting by the tilt angle θ 2 in the range of 25 degrees to 45 degrees from the crystal axis of [0001] or [000-1] toward the <01-10> direction. Microscopically, the local area 32 including the edge P1 of the pn-junction 26 has the principal plane that is normal or perpendicular to the C2-axis tilting by the tilt angle θ 2 in the range of 25 degrees to 45 degrees from the crystal axis of [0001] or [000-1] toward the <01-10> direction. The local area 32 is in contact with the first passivation film 114 so as to form an interface between the local area 32 made of SiC and the first passivation film 114 made of an insulator. The limited range of the tilt angle θ 2 defining the normal to the principal plane of the local area 32 provides the reduced density of dangling bonds that are present on the interface between the local area 32 and the first passivation film 114. The reduced density of dangling bonds reduces the density of interface states on the interface between the local area 32 and the first passivation film 114, thereby reducing the leakage of reverse current through the pn-junction 26 and providing the improved current characteristics.

### Third Embodiment:

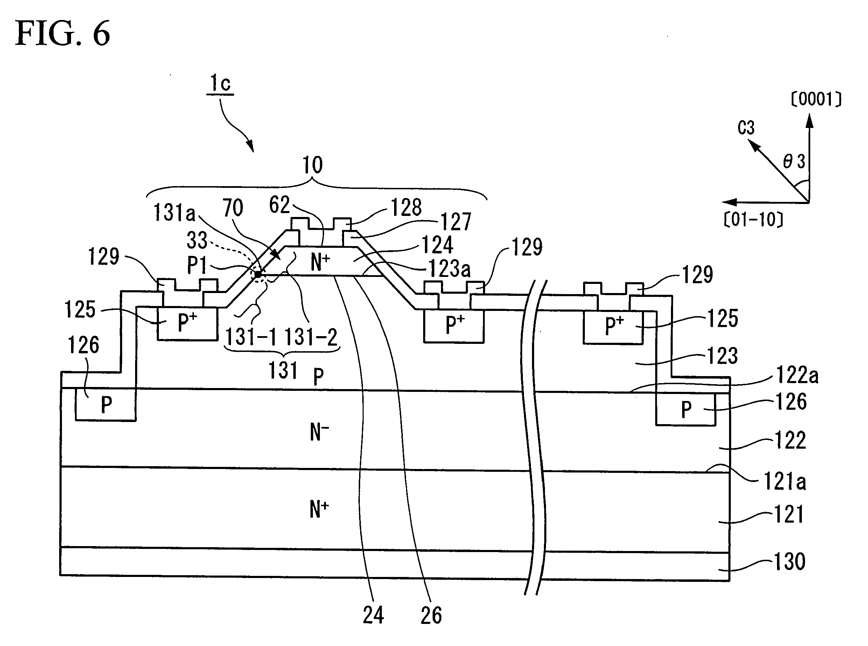

A third preferred embodiment of the present invention will be described. FIG. 6 is a fragmentary cross sectional elevation view illustrating one of a plurality of unit cells of a 4H-SiC semiconductor device in accordance with a third preferred embodiment of the present invention. The third preferred embodiment provides a 4H-SiC semiconductor device 1c that acts as a SiC-NPN-transistor. The 4H-SiC semiconductor device 1c includes a plurality of unit cells 10 that are aligned. FIG. 6 illustrates only one of the plurality of unit cells 10. The 4H-SiC semiconductor device 1c has a stack that comprises an N⁺-bulk layer 121, an N⁻-drift layer 122, a P-base layer 123 and an N⁺-emitter layer 124. The N⁺-bulk layer 121 has a main component of 4H-SiC that has a high concentration of an n-type impurity. The N⁺-bulk layer 121 serves as an n-SiC substrate. The N⁺-bulk layer 121 has a principal plane 121a. The N⁻-drift layer 122 is disposed on the principal plane 121a of the N⁺-bulk layer 121. The N⁻-drift layer 122 has a main component of 4H-SiC that has a low concentration of an n-type impurity. The N⁻-drift layer 122 is lower in the impurity concentration and the electrical conductivity than the N⁺-bulk layer 121. The N⁻-drift layer 122 has a principal plane 122a that further includes a predetermined region and a peripheral region that surrounds the predetermined region. The P-base layer 123 is disposed on the predetermined region of the principal plane 122a of the N⁻-drift layer 122. The P-base layer 123 has a principal plane 123a. As compared to the N⁻-drift layer 122, the N⁺-bulk layer 121 has a high conductivity and a low resistivity so as to reduce a series resistance of the semiconductor device 1c. As compared to the N⁺-bulk layer 121, the N⁻-drift layer 122 has a low conductivity and a high resistivity so as to improve a withstand voltage characteristic of the semiconductor device 1c. The thickness and the impurity concentration of the N⁻-drift layer 122 may be decided so as to ensure a required withstand voltage characteristic. The N⁺-emitter layer 124 has a main component of 4H-SiC that has a high concentration of an n-type impurity. The N⁺-emitter layer 124 is disposed on the principal plane 123a of the P-base layer 123 so as to form an interface 24 between the P-base layer 123 and the N⁺-emitter layer 124. The interface 24 also forms a pn-junction 26. The N⁺-emitter layer 124 may be formed by a CVD (Chemical Vapor Deposition) method. Alternatively, the N⁺-emitter layer 124 may be formed by introducing an n-type impurity into the principal plane 123a of the P-base layer 123 by an ion implantation and then annealing at a temperature of not less than 1500°C.

The stack of the P-base layer 123 and the N⁺-emitter layer 124 includes a ridged structure 70 that has sloped side walls 131 and a flat top surface 62. The P-base layer 123 has a base portion and a ridged portion that is formed over the base portion. The base portion has flat upper surfaces. The ridged portion has the principal plane 123a and first sloped side walls 131-1. The N⁺-emitter layer 124 has second sloped side walls 131-2 and the flat top surface 62. Thus, the ridged structure 70 comprises the ridged portion of the P-base layer 123 and the N⁺-emitter layer 124. At least one of the sloped side walls 131 comprises the combined first and second sloped side walls 131-1 and 131-2 that are aligned to each other. The sloped side walls 131 tilt from the interface 24. The pn-junction 26 has an edge P1 that is positioned at a boundary between the first and second sloped side walls 131-1 and 131-2. Namely, the edge P1 of the pn-junction 26 is positioned on the sloped side wall 131.

P⁺-base contact layers 125 are selectively provided in an upper region of the base portion of the P-base layer 123. A P-device terminal layer 126 is selectively provided in the peripheral region of the N⁻-drift layer 122.

A passivation film 127 extends over the sloped side walls 131, a part of the flat top surface 62, the upper surface of the base portion of the P-base layer 123, the P-device terminal layer 126, and the upper surface of the peripheral region of the N⁻-drift layer 122. The passivation film 127 covers the sloped side walls 131 that include the edge P 1 of the pn-junction 26. The passivation film 127 is provided in order to passivate or protect the pn-junction 26. Therefore, the passivation film 127 passivates or protects at least the edge P1 of the pn-junction 26. At least one of the sloped side wall 131 includes a local area 33 that further includes the edge P1 of the pn-junction 26. Thus, the passivation film 127 may typically cover the local area 33 of at least one of the sloped side walls 131 so as to passivate or protect at least the edge P1 of the pn-junction 26. The passivation film 127 is made of an insulator such as thermal oxide or thermal oxynitride.

The passivation film 127 has an opening which is positioned over the flat top surface 62 of the N⁺-emitter layer 124. An emitter electrode 128 is provided in the opening so that the emitter electrode 128 has an ohmic contact with the flat top surface 62 of the N⁺-emitter layer 124. The passivation film 127 also has other openings that are positioned over the P⁺-base contact layers 125. Base electrodes 129 are provided in the other opening so that the base electrodes 129 have ohmic contacts with the P⁺-base contact layers 125. The emitter electrode 128 may be formed as follows. A nickel (Ni) layer is deposited on the exposed portion of the flat top surface 62 of the N⁺-emitter layer 124 and the passivation film 127 before an annealing process is carried out at a temperature of not lower than 900°C to form the emitter electrode 128. The base electrodes 129 are formed as follows. A titanium (Ti) layer is deposited on the exposed portions of the P⁺-base contact layers 125 and the passivation film 127. An aluminum (Al) layer is further deposited on the titanium (Ti) layer to form a lamination of the titanium (Ti) layer and the aluminum (Al) layer before an annealing process is carried out at a temperature of not lower than 900°C to form the base electrodes 129.

The N⁺-bulk layer 121 has another plane opposite the principal plane 121a. A collector electrode 130 is disposed on the opposite plane of the N⁺-bulk layer 121 so that the collector electrode 130 has an ohmic contact with the N⁺-bulk layer 121. The collector electrode 130 may be formed as follows. A nickel (Ni) layer is deposited on the opposite plane of the N⁺-bulk layer 121 before an annealing process is carried out at a temperature of not lower than 900°C to form the collector electrode 130.

The principal plane 121a of the N⁺-bulk layer 121 is vertical to a crystal axis of [0001]. The principal plane 121a is parallel to another crystal axis of [01-10] that is perpendicular to the crystal axis of [0001]. The principal plane 121a is a (0001) plane. At least one of the side walls 131 has a principal plane 131a that is vertical to a C3-axis that tilts by a tilt angle θ 3 from the crystal axis of [0001] toward the crystal axis of [01-10]. The tilt angle θ 3 is preferably in a range of 25 degrees to 45 degrees, and more preferably in a range of 30 degrees to 39 degrees, and optimally 35.3 degrees. When the tilt angle θ 3 is 35.3 degrees, the principal plane 131a is a (03-38) plane of hexagonal crystal. The (03-38) plane of hexagonal crystal corresponds to a (001) plane of cubic crystal. When an insulating layer is adjacent to the (03-38) plane of the hexagonal crystal of the SiC semiconductor, an insulator-semiconductor interface between the insulating layer and the (03-38) plane of the hexagonal crystal has a lowest density of interface states. The tilt angle θ 3 may vary depending on erroneous variations of the manufacturing conditions. Thus, it is extremely preferable for the tilt angle θ 3 to be in a range of 34 degrees to 36 degrees.

The ridged structure 70 has the sloped side walls 131, at least one of which has the local area 33 that includes the edge P1 of the pn-junction 26. The passivation film 127 covers at least the local area 33 in order to protect or passivate the pn-junction 26. The local area 33 comprises the edge P1 and adjacent areas thereto. In order to reduce the density of interface states between the local area 33 and the passivation film 127, it is preferable for the local area 33 to have a principal plane that is normal or perpendicular to the C3-axis that tilts by the tilt angle θ 3 from the crystal axis of [0001] toward the crystal axis of [01-10], wherein the tilt angle θ 3 satisfies the above-described condition.

Microscopically, the local area 33 has a principal plane that is vertical to the C3-axis tilting by the tilt angle θ 3 from the crystal axis of [0001] toward the crystal axis of [01-10]. The tilt angle θ 3 is preferably in a range of 25 degrees to 45 degrees. The local area 33 means a small area that forms the principal plane that includes the edge P1 of the pn-junction 26. Thus, the local area 33 may include not only the edge P1 of the pn-junction 26 but also a peripheral area that surrounds the edge P1. At least one of the side walls 131 may have a surface roughness. However, if at least one of the side walls 131 has a roughness-free surface, the principal plane 131a of at least one of the side walls 131 is identical with the principal plane of the local area 33. Macroscopically, the principal plane 131a of at least one of the side walls 131 is identical with the principal plane of the local area 33, regardless of the surface roughness.

Alternatively, the principal plane 121a of the N⁺-bulk layer 121 may be a (000-1) plane. The principal plane 131a of at least one of the side walls 131 is normal or perpendicular to the C3-axis that may tilt by the tilt angle θ 3 from the crystal axis of [000-1] toward the crystal axis of [01-10] or its equivalent.

Namely, the principal plane 131 a is normal or perpendicular to the C3-axis that tilts by the tilt angle θ 3 in the range of 25 degrees to 45 degrees from the crystal axis of [0001] or [000-1] toward a <01-10> direction. When the tilt angle θ 3 is 35.3 degrees, the C3-axis is normal to a {03-38} plane.

The reason the above-described tilt angle θ 3 is preferably in the range of 25 degrees to 45 degrees is the same as described above with reference to FIG. 2. Duplicate descriptions will thus be omitted.

Decreasing the number of dangling bonds per unit area decreases the density of interface states, thereby decreasing the leakage of current. In order to reduce the leakage of current, it is preferable for the number of dangling bonds per unit area to be not more than 0.3E16 (cm⁻²), and thus the tilt angle is in a range of 25 degrees to 45 degrees. More preferably, the number of dangling bonds per unit area is not more than 0.2E16 (cm⁻²), and thus the tilt angle is in a range of 30 degrees to 39 degrees. The optimum tilt angle is 35.3 degrees to minimize the number of dangling bonds.

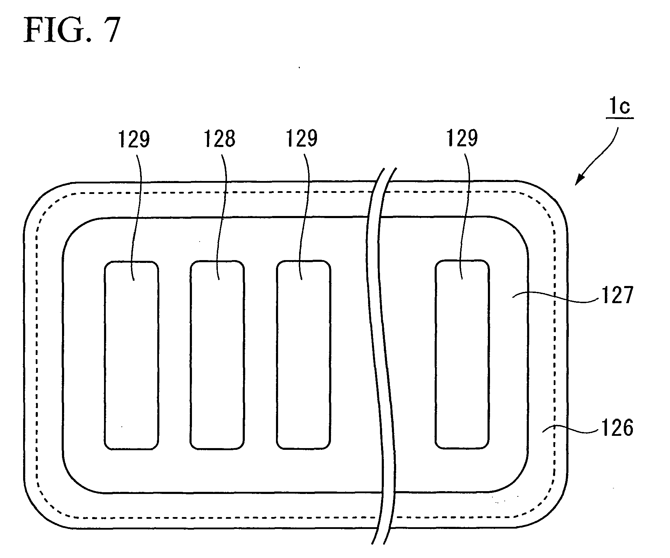

FIG 7 is a fragmentary plan view in a direction of [000-1] illustrating the semiconductor device 1c of FIG. 6. At least one of the base electrodes 129 and the emitter electrode 128 has a generally rectangle shape with rounded corners in plan view, which has a longitudinal direction that is parallel to the <11-20> axis. The P-device terminal layer 126 extends in a ring shape which encompasses the unit cell 10 in plan view.

As described above, the semiconductor 1c includes the stack of the P-base layer 123 and the N⁺-emitter layer 124 that are adjacent to each other. The stack has the ridged structure 70 that has the flat top surface 62 and the sloped side walls 131, and includes the pn-junction 26 on the interface 24 between the P-base layer 123 and the N⁺-emitter layer 124. The pn-junction 26 has the edge P1 that is the one dimensional boundary between the first and second sloped side walls 131-1 and 131-2 of the P-base layer 123 and the N⁺-emitter layer 124. At least one of the sloped side walls 131 includes the local area 33 that further includes the edge P1 of the pn-junction 26. Macroscopically, at least one of the sloped side walls 131 has the principal plane that is normal or perpendicular to the C3-axis tilting by the tilt angle θ 3 in the range of 25 degrees to 45 degrees from the crystal axis of [0001] or [000-1] toward the <01-10> direction. Microscopically, the local area 33 including the edge P1 of the pn-junction 26 has the principal plane that is normal or perpendicular to the C3-axis tilting by the tilt angle θ 3 in the range of 25 degrees to 45 degrees from the crystal axis of [0001] or [000-1] toward the <01-10> direction. The local area 33 is in contact with the passivation film 127 so as to form an interface between the local area 33 made of SiC and the passivation film 127 made of an insulator. The limited range of the tilt angle θ 3 defining the normal to the principal plane of the local area 33 provides the reduced density of dangling bonds that are present on the interface between the local area 33 and the passivation film 127. The reduced density of dangling bonds reduces the density of interface states on the interface between the local area 33 and the passivation film 127, thereby reducing the leakage of reverse current through the pn-junction 26 and increasing the current gain of the semiconductor device 1c. Thus, a limited range of the tilt angle θ 3 improves the current characteristics of the semiconductor device 1c.

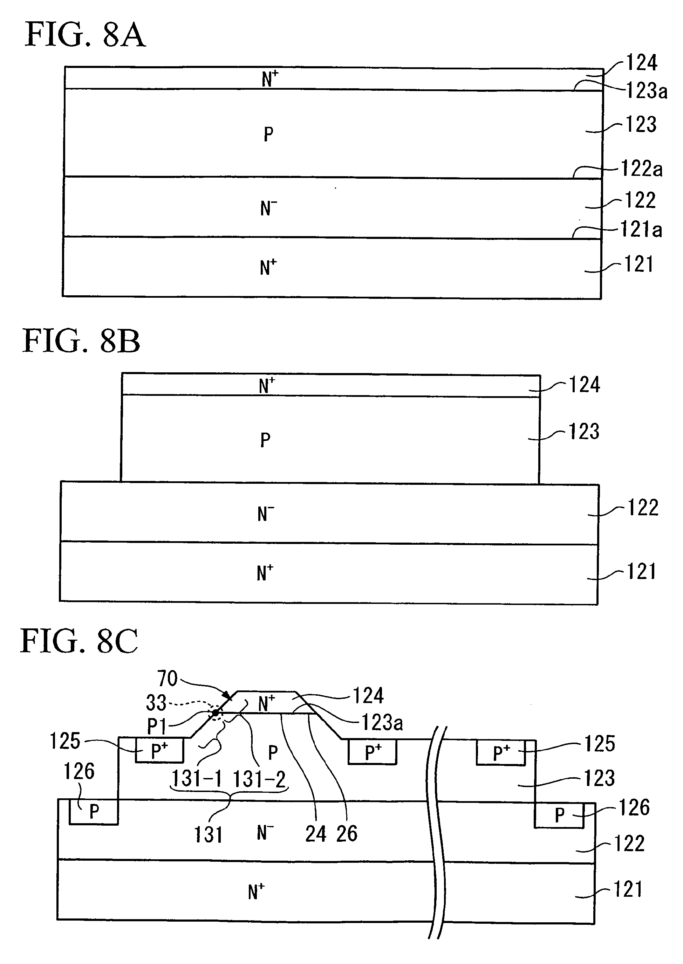

A method of forming the above-described semiconductor device 1c will be described. FIGS. 8A through 8E are fragmentary cross sectional elevation views illustrating sequential steps involved in a method of forming the semiconductor device of FIG. 6.

As shown in FIG. 8A, the N⁺-bulk layer 121 as a substrate is prepared. The N⁺-bulk layer 121 has the principal plane 121a. The N⁻-drift layer 122 is deposited on the principal plane 121a of the N⁺-bulk layer 121 by an available deposition method such as a CVD (Chemical Vapor Deposition) method. The N⁻-drift layer 122 has the principal plane 122a. As compared to the N⁻-drift layer 122, the N⁺-bulk layer 121 has a high conductivity and a low resistivity so as to reduce a series resistance of the semiconductor device 1c. As compared to the N⁺-bulk layer 121, the N⁻-drift layer 122 has a low conductivity and a high resistivity so as to improve a withstand voltage characteristic of the semiconductor device 1c. The thickness and the impurity concentration of the N⁻-drift layer 122 may be decided so as to ensure a required withstand voltage characteristic.

The P-base layer 123 is deposited on the principal plane 122a of the N⁻-drift layer 122 by an available deposition method such as a CVD (Chemical Vapor Deposition) method. The P-base layer 123 has a necessary concentration of impurity and a necessary thickness for forming a base region of the transistor. The P-base layer 123 has the principal plane 123a. The N⁺-emitter layer 124 is deposited on the principal plane 123a of the P-base layer 123 by an available deposition method such as a CVD (Chemical Vapor Deposition) method, thereby forming the interface 24 between the P-base layer 123 and the N⁺-emitter layer 124. The interface 24 has the pn-junction 26. Alternatively, the N⁺-emitter layer 124 may be formed by introducing an n-type impurity into the principal plane 123a of the P-base layer 123 by an ion implantation and then annealing at a temperature of not lower than 1500°C.

As shown in FIG. 8B, the P-base layer 123 and the N⁺-emitter layer 124 in the peripheral region are selectively removed by a dry etching process so as to form a groove that extends in the peripheral region.

As shown in FIG. 8C, an etching mask that is not illustrated is formed on an upper surface of the N⁺-emitter layer 124. The etching mask has a pattern that includes windows. The stack of the N⁺-bulk layer 121, the N⁻-drift layer 122, the P-base layer 123 and the N⁺-emitter layer 124 with the etching mask is placed in a dry etching chamber in order to carry out a dry etching process under the following conditions. The etching gas similar to that of the first embodiment can be used.

The etching process can also be carried out in the similar conditions to those of the first embodiment so as to form the ridged structure 70 that has the sloped side walls 131 and the flat top surface 62. The voltage to be applied to the sample stage is adjusted so that macroscopically at least one of the sloped side walls 131 has the principal plane that is normal or perpendicular to the axis tilting by the tilt angle θ 3 in the range of 25 degrees to 45 degrees from the crystal axis of [0001] toward the crystal axis of [01-10]. Defining the ridged portion 70 by the etching process defines the edge P1 of the pn-junction 26 on the interface 24 between the P-base layer 123 and the N⁺-emitter layer 124. Microscopically, at least one of the sloped side walls 131 includes the local area 33 that further includes the edge P1 of the pn-junction 26, wherein the local area 33 has the principal plane that is normal or perpendicular to the C3-axis tilting by the tilt angle θ 3 in the range of 25 degrees to 45 degrees from the crystal axis of [0001] toward the crystal axis of [01-10].

Further, the P-device terminal layer 126 and the P⁺-base contact layers 125 are formed as follows. An oxide film is deposited by a CVD (Chemical Vapor Deposition) method on the N⁻-drift layer 122, the P-base layer 123 and the N⁺-emitter layer 124. A resist mask is further prepared over the oxide film by exposure and development processes. The oxide film is selectively exposed to an acid solution to selectively remove the oxide film over a selected region of the N⁻-drift layer 122. The oxide film is used as a mask for carrying out a selective ion-implantation of a p-type impurity such as Al into the selected region. The oxide film as used is then removed. Another oxide film is deposited by a CVD (Chemical Vapor Deposition) method on the N⁻-drift layer 122, the P-base layer 123 and the N⁺-emitter layer 124. Another resist mask is further prepared over the other oxide film by further exposure and development processes. The other oxide film is selectively exposed to the acid solution to selectively remove the other oxide film over other selected regions of the P-base layer 123. The other oxide film is used as another mask for carrying out a further selective ion-implantation of a p-type impurity such as Al into the other selected regions of the P-base layer 123. The other oxide film as used is removed. A heat treatment is carried out at a temperature of not lower than 1500°C so as to activate the implanted p-type impurity, thereby forming the P-device terminal layer 126 and the P⁺-base contact layers 125.

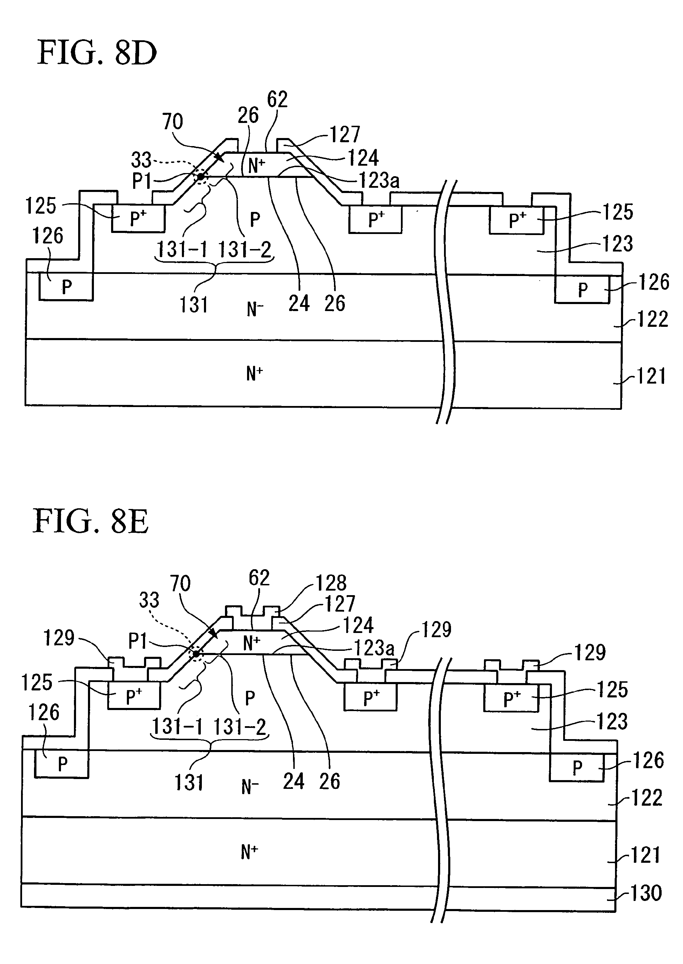

As shown in FIG. 8D, the passivation film 127 may be formed as follows. A thermal oxidation process or a thermal oxynitration process is carried out to form a thermal oxide film or a thermal oxynitride film over the N⁻-drift layer 122, the P-base layer 123 and the N⁺-emitter layer 124. A resist mask is prepared over the thermal oxide or oxynitride film by lithography processes. The thermal oxide or oxynitride film is selectively exposed to an acid solution to selectively remove the thermal oxide or oxynitride film, thereby forming an opening over the flat top surface of the N⁺-emitter layer 124 and forming other openings over the flat upper surface of the P-base layer 123. As a result, the thermal oxide or oxynitride film serves as the passivation film 127. The passivation film 127 passivates and protects the pn-junction 26.

As shown in FIG 8E, the emitter electrode 128 and base electrodes 129 may be formed by a lift off method. The emitter electrode 128 may be formed by depositing a nickel (Ni) layer on the exposed portion of the flat top surface 62 of the N⁺-emitter layer 124. The base electrodes 129 may be formed by depositing a titanium (Ti) layer on the exposed portion of the upper surface of the P⁺-base contact layers 125 and further depositing an aluminum (Al) layer on the titanium (Ti) layer to form a lamination of the titanium (Ti) layer and the aluminum (Al) layer. The collector electrode 130 may be formed by depositing a nickel (Ni) layer on the opposite plane of the N⁺-bulk layer 121. An annealing process is carried out at a temperature of not lower than 900°C to form an ohmic contact between the emitter electrode 128 and the N⁺-emitter layer 124, another ohmic contact between the base electrodes 129 and the P⁺-base contact layers 125, and still another ohmic contact between the collector electrode 130 and the N⁺-bulk layer 121, thereby completing the semiconductor device 1c.

As described above, macroscopically, at least one of the sloped side walls 131 has the principal plane that is normal or perpendicular to the C3-axis tilting by the tilt angle θ 3 in the range of 25 degrees to 45 degrees from the crystal axis of [0001] or [000-1] toward the <01-10> direction. Microscopically, the local area 33 including the edge P1 of the pn-junction 26 has the principal plane that is normal or perpendicular to the C3-axis tilting by the tilt angle θ 3 in the range of 25 degrees to 45 degrees from the crystal axis of [0001] or [000-1] toward the <01-10> direction. The local area 33 is in contact with the passivation film 127 so as to form an interface between the local area 33 made of SiC and the passivation film 127 made of an insulator. The limited range of the tilt angle θ 3 defining the normal to the principal plane of the local area 33 provides the reduced density of dangling bonds that are present on the interface between the local area 33 and the passivation film 127. The reduced density of dangling bonds reduces the density of interface states on the interface between the local area 33 and the passivation film 127, thereby reducing the leakage of reverse current through the pn-junction 26 and increasing the current gain of the semiconductor device 1c. Thus, a limited range of the tilt angle θ 3 improves the current characteristics of the semiconductor device 1c.

The present invention is directed to the passivation of the pn-junction while reducing the leakage of current. The present invention is applicable to any types of semiconductor devices that include the stack of the first and second conductivity type semiconductor layers adjacent to each other via the pn-junction, wherein the first and second conductivity type semiconductor layers have a main component of 4H-SiC, and the stack has the sloped side walls, at least one of which includes the local area that further includes the edge of the pn-junction, and the local area is in contact with the passivation film to form a semiconductor-insulator interface between the local area and the passivation film. For example, the present invention is applicable to not only the above described SiC-PiN diode and SiC-NPN transistor but also an SiC thyristor, an SiC-SIT (static induction transistor) and an SiC-GTO (gate turn off thyristor).

While preferred embodiments of the invention have been described and illustrated above, it should be understood that these are exemplary of the invention and are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

## Claims

1. A semiconductor device comprising:
a passivation film (103, 114, 115, 127) ;
a first semiconductor layer (101, 112, 123) that has a first main component of 4H-SiC of a first conductivity type; and
a second semiconductor layer (102, 113, 124) that has a second main component of 4H-SiC of a second conductivity type, the second semiconductor layer (102, 113, 124) having a pn-junction (26) with the first semiconductor layer (101, 112, 123), the pn-junction (26) having a junction edge (PI),
the first and second semiconductor layers (101, 102, 112, 113, 123, 124) further including a local area (31, 32, 33) that includes the junction edge (PI), the local area (31, 32, 33) having a first principal plane that interfaces with the passivation film (103, 114, 115, 127), and a normal (C1, C2, C3) to the first principal plane being tilted by a first tilt angle (θ 1, θ 2, θ 3) in a range of 25 degrees to 45 degrees from a first axis of [0001] or [000-1] toward a second axis of <01-10>.

2. The semiconductor device according to claim 1, wherein the first tilt angle (θ1, θ 2, θ 3) is in a range of 30 degrees to 39 degrees.

3. The semiconductor device according to claim 1, wherein the first tilt angle(θ 1, θ 2, θ 3) is 35.3 degrees and the first principal plane is a {03-38} plane.

4. The semiconductor device according to claim 1, wherein the pn-junction (26) is distanced from a cross of the first principal plane and another plane that is perpendicular to a third axis that tilts by a second tilt angle of less than 25 degrees or more than 45 degrees from the first axis of [0001] or [000-1] toward the second axis of <01-10>.

5. The semiconductor device according to claim 1, wherein the passivation film (103, 114, 115, 127) comprises an insulation film so as to form a semiconductor-insulator interface with the first principal plane.

6. The semiconductor device according to claim 1, wherein the first and second semiconductor layers (101, 102, 112, 113, 123, 124) have at least one sloped side wall (104, 119, 131) that includes the local area (31, 32, 33), and the at least one sloped side wall (104, 119, 131) has the first principal plane and a semiconductor-insulator interface with the passivation film (103, 114, 115, 127).

7. The semiconductor device according to claim 1, wherein the first and second semiconductor layers (101, 102, 112, 113, 123, 124) have a ridged structure (70) that has sloped side walls (104, 119, 131) and the pn-junction (26), and each of the sloped side walls (104, 119, 131) includes the local area (31, 32, 33) and comprises the first principal plane that interfaces with the passivation film (103, 114, 115, 127).
